Europäisches Patentamt

**European Patent Office**

Office européen des brevets

(11) Publication number: **0 042 109**
**B1**

(12) **EUROPEAN PATENT SPECIFICATION**

(45) Date of publication of patent specification: **02.10.85**

(51) Int. Cl.⁴: **G 03 C 1/72, G 03 F 7/10**

(21) Application number: **81104277.9**

(22) Date of filing: **03.06.81**

(54) Lithographic process and resulting article.

(30) Priority: **03.06.80 US 156029**

(43) Date of publication of application:
**23.12.81 Bulletin 81/51**

(45) Publication of the grant of the patent:
**02.10.85 Bulletin 85/40**

(84) Designated Contracting States:
**BE DE FR IT NL SE**

(56) References cited:
EP-A-0 018 653
WO-A-80/01020

CHEMICAL ABSTRACTS, volume 89, no. 4, July 15, 1978 page 649, abstract 34117w COLUMBUS OHIO (US)
CHEMICAL ABSTRACTS, volume 79, no. 22, December 3, 1973, page 344, abstract 131400j COLUMBUS OHIO (US)
APPLIED PHYSICS LETTERS, volume 29, no. 10, November 15, 1976 NEW YORK (US) A. YOSHIKAWA et al. "A novel inorganic photoresist utilizing Ag photodoping in Se-Ge glass films" pages 677-679

(73) Proprietor: **Western Electric Company, Incorporated**
**222 Broadway**
**New York, NY 10038 (US)**

(72) Inventor: **Tai, King Lien**
**344 Park Avenue**
**Berkeley Heights New Jersey 07922 (US)**

(74) Representative: **Blumbach Weser Bergen Kramer Zwirner Hoffmann Patentanwälte**
**Radeckestrasse 43**
**D-8000 München 60 (DE)**

(56) References cited:
EXTENDED ABSTRACTS, volume 80, October 2, 1980, abstract 319 PRINCETON NEW JERSEY (US) K.L. TAI et al. "Edge-sharpening effect in Ag2Se/GeSe inorganic resist", pages 826-828
EXTENDED ABSTRACTS, volume 80, 2 October 1980, abstract 318 PRINCETON NEW JERSEY (US) R.G. WADIMSKY et al. "Wet chemical processing of the inorganic resist GexSe1-x" pages 824-825

EP 0 042 109 B1

# Description

## Background of the invention

The invention refers to a lithographic process and resulting article, as defined in the preamble clause of claim 1. A typical application field of this process is the fabrication of integrated circuits— e.g., semiconductor, magnetic and optic, as well as discrete devices. One class of such devices of primary consequence in connection with the invention is large scale integrated devices (LSI). As presently fabricated, lithography is involved at two stages: first, in the preparation of discrete masks and, second, in the replication of mask patterns on the device.

Lithographic patterns, whether on discrete masks or on the device undergoing fabrication, are produced by irradiation of actinic "resist" layers. The invention is concerned with processes in which actinic properties of the resist are a consequence of photoinduced migration of metal into glossy material.

Advancement in integrated circuitry is marked by corresponding developments in lithography. Early small scale integration (SSI) and subsequent medium scale integration (MSI) generally depended upon manual circuit design with artwork initially by a draftsman. Present day LSI and the emerging era of very large scale integration (VLSI) depend to an increasing degree on computer aided design (CAD).

In a prevalent system, the output of the CAD is directly interfaced with a patterning machine. One such patterning machine, known as electron beam exposure system (EBES) is described in *IEEE Transactions on Electron Devices* Vol. ED-22, No. 7, page 385, entitled "EBES: A Practical Electron Lithographic System" (July 1975). EBES is a raster scan machine which depends upon selective exposure of an actinic resist layer by a monitored scanning electron beam. An alternative approach involves vector scanning in which such a beam scans a specific positioned region to produce patterns which are finally linked to other such regions to complete the circuit.

Primary patterning, whether by state of the art e-beam, by earlier techniques largely dependent upon visible or UV radiation, or whether based on ion beam delineation which many believe may serve for future generations, may be applied in various ways.

Discrete masks may be on the same scale as that of the desired circuit pattern. Such 1:1 masks may be repeated on a mask to represent the ten's of duplicate circuits typically fabricated on the prevalent 10 or 13 centimeter (four or five inch) wafer. An alternate approach is based on a "reticle" with dimensions enlarged with respect to final circuits. Device patterning then involves a reduction and sequential "step and repeat" to, again, result in the typical many chip wafer. Fabrication of semiconductor circuitry may require from a few to over a dozen different masks.

Discrete masks, whether primary patterned "master masks" or replicated "working masks" are, in ordinary practice, delineated by radiation in actinic resist layers which, as developed, yield aperture delineated patterns. Patterns are usually reproduced in underlying "hard" material, such as, chromium or chromium oxide which is, in turn, supported by a glass or other substrate transparent to the intended processing radiation.

However produced, discrete masks then serve to define a radiation image which is made incident on processing resist in intimate contact with the device undergoing processing. Processing at each level involves such selective irradiation, development to produce the pattern delineated masking layer and a fabrication step, such as selective etching, ion implantation, electroplating, etc.

A procedure alternative to mask processing relies upon direct patterning of the processing layer by the information-modulated beam. This "direct processing" considered by many a likely candidate for the fine dimensioned lithography of future VLSI may rely on electron beams, as in present primary patterning, or may use an alternate source, such as, an ion source. Should enconomics so dictate, such direct processing would become a significant market factor for design rules involving features of the order of 1 μm.

Resists, whether intended for primary replication or for secondary replication are predominantly organic. Polymer layers are locally modified by radiation to increase or decrease ease of removal likely during a subsequent development step in which the entire layer is subjected to a solvent. Retention of irradiated portions to result in negative tone may be the consequence of radiation-induced cross-linking. Positive tone may result from radiation-induced depolymerization. A popular positive tone resist depends upon an alternative mechanism in which the resist is predominantly a matrix material selected, not for its actinic properties but for its resistance to processing chemistry. Radiation response is due to inclusion of a relatively small amount of a blended ingredient which is modified by radiation to permit dissolution of matrix.

While commercial lithographic device fabrication is almost invariably based on use of organic polymer resists, considerable interest has been evoked by inorganic chalcogenide glass-based materials. In these, light causes a metal, such as silver, to migrate from the surface into the bulk of the glass to yield a negative tone (to reduce solubility in a solvent developer).

Said metal is supplied from a practically unlimited metal source in form of a metal thin film on top of the glass-based resist, see Applied Physics Letters, Vol. 29, No. 10, Nov. 15, 1976, EP—A—20776 and US—A—41 27 414. While migration of a number of metals may be photoinduced, most promising candidates are silver and copper. Selection of glassy material is dependent largely on ease or processing—e.g., adhesion, application, removal—and compositions include the many chalcogenides, as well as other inorganic mixtures. The inorganic resist was brought to its present level of development in accordance with the disclosure of EP—A—18653 (falling within the terms of Article 54 (3) EPC). An exemplary resist described in that disclosure is based on a layer of germanium/selenium glass with photoinduced silver being yielded by a source layer of silver selenide.

Interest in inorganic resists derives primarily from relative stability to processing chemistry. For example, contemplated solution to step coverage by resist on partially fabricated devices involves an inorganic resist layer over a thin shielding layer and, in turn, a thick (several μm) polymer layer. The inorganic resist may replace both the organic resist and shielding layer to yield a two-layer instead of a three-layer process.

As practiced, delineation by the inorganic resist route is familiar. Radiation exposure is followed ultimately by removal with a solvent, plasma, or other procedure which discriminates between exposed and unexposed regions. In usual solvent processing, there is an intermediate stripping in which metal source material is removed from the surface. To ensure maximum sensitivity, excess source material is used so that stripping effects removal of overlying source material from exposed, as well as unexposed, regions.

Regardless of the type of resist material used, design rules in LSI fabrication are, for photolithographic systems, approaching the Rayleigh or λF limit of resolution where λ is the wavelength and F is a description of the quality of the optics of the system as defined in texts of geometrical optics (for example, on pages 6—101 of the 3rd edition of the *American Institute of Physics Handbook*, McGraw-Hill 1972). Fabrication of contemplated VLSI with feature dimensions below the present design rule ~2—3 μm has provoked interest in short wavelength radiation—e.g., replacement of present near-UV replication radiation by far UV, X-ray, or electrons. Since the effective wavelength of such radiation can be small, the resulting systems are not necessarily limited by λF, but rather by the resist materials, by scattering of electrons, etc. In polymer-based resists, other factors, such as molecular weight distribution (of particular consequence in negative tone) and proximity effects (due to the functional secondary electrons in e-beam or ion beam delineation) restrict resolution.

These resist characteristics, to date, have for design rules of a few micrometers and smaller prevented dimensionally controlled one-step replication of lines and spaces. For example, in an optical projection system, the relative light intensity distributions are different for different sizes of features. It requires longer exposure for smaller features than for the larger features. Therefore, if the exposure time is chosen for smaller features, then it leads to excessive enlargement of the larger features. This gives rise to the practice of mask biasing. For discriminating circuitry, masks are biased with apertured regions of dimensions relatively large for small features and to compensate for the change in line-space dimension ratio universally experienced upon replication.

## Summary of the invention
### Problem

Lithographic fabrication techniques, as used for design rules of a few micrometers or smaller, are resolution-limited at dimensions substantially larger than theoretical Rayleigh (λF) limits. Errors in feature dimensions may result from the following:

1. Poor linewidth control: slight over- or underexposure changes the dimensions of the printed feature.

2. Poor definition of edges of features. Because of diffraction, there is gradual, continuous change in exposure between the intentionally illuminated and nonilluminated zones so that an uncertainty exists with respect to feature dimensions after processing. The acuity of change in irradiance from dark to illuminated zones depends on λF.

3. Errors due to positioning of masks with respect to the wafer. Since very small and large features require now different exposure the number of masks and the related errors may be increased. Furthermore, different types of features, such as isolated gaps and isolated lines cannot be simultaneously printed with an unbiased mask. This may, again, increase the number of masks and positioning steps required.

4. Errors in correspondence between the mask and the printed feature. Presently, mask biasing or a change in the dimension of the mask feature is required to print predefined features. Thus, there is no simple correspondence between printed and mask features (whether 1:1 or reduction).

5. Proximity effects in electron resists due to electron scattering result in unintended increased exposure for proximate regions relative to isolated regions.

The effect is imposition of resolution limits either by the phenomenon, itself, or by responsive procedural complications.

### Solution

As has been found, a phenomenon associated with inorganic resist can be used as the basis for improved lithographic resolution. Controlled amount of source-metal material in connection with suitable irradiation conditions results in measurable depletion at the surface during photomigration to result in a concentration gradient in the source metal layer. Lateral diffusion of metal from "dark" regions across the interfacial boundary into irradiated regions results in local depletion of metal on the "unirradiated side of the interface and increased concentration on the "irradiated side". The increased concentration results in increased metal as photomigrated and is, therefore, equivalent to increased exposure; while the opposite is true on the dark side of the interface. Resulting enhanced edge acuity results in increased resolution. According to the invention, based on that phenomenon the lithographic resolution can be improved for the process under discussion if the characterizing features of claim 1 are observed. Consequences of the increased edge acuity include:

(1) Resolution more closely approaches the theoretical Rayleigh $\lambda F$ limit. While for organic resists, a modulation transfer function (MTF) of 0.6 is required to define periodic lines and spaces, photomigration of a metal on inorganic resists reduces this value to 0.2. Stated differently, a threefold lesser deviation from an average grey is adequate to define a zone as "irradiated" or "nonirradiated", removing most of the uncertainty for the marginal irradiation or lack of irradiation at edges. In work conducted to date, lines and spaces of 0.67 $\lambda F$ have been attained with lateral metal migration, while resists without were limited to lines and spaces of $\lambda F$.

(2) It is found that isolated lines and isolated gaps bearing the same relative dimensions as those on the mask may be printed simultaneously. In processing terminology, this equates to the permitted use of unbiased masks— that is, masks in which features both much larger than $\lambda F$ and even smaller than $\lambda F$ may bear the same dual relationship to gaps on the mask as on the desired circuitry.

(3) Increased edge acuity permits improved line width control.

(4) Improved edge resolution offers a means for suppressing proximity effects for procedures dependent upon secondary electrons.

(5) The observed phenomenon in accordance with which enhanced edge acuity is a function of the lateral metal diffusion in response to a depletion in bright regions gives rise to a parameter to be considered as well when tailoring a system for particular requirements. Namely the diffusivity of metal within the metal-source layer (as affected by material choice, temperature, etc.) Affects the exposure time relative to exposure intensity because the rates of photomigrating metal and laterally diffusing metal) are different, with the latter being relatively slow.

Detailed description
General

Inorganic resist systems depending upon photoinduced migration of metal to alter ease of removability of glassy material may be optimized in terms of composition and processing parameters to result in improved edge acuity: Improvement is attributed to lateral diffusion of metal within the surface layer of the source metal. Lateral diffusion is responsive to the concentration gradient resulting from depletion in the irradiated regions. Depletion is a direct consequence of the photomigration mechanism itself, in accordance with which the metal is caused to permeate the body of glass underlying the source metal layer.

Compositional optimization is dependent upon maximized or otherwise desired rate of lateral diffusion relative to rate of photomigration. Parameters of concern relate to diffusivity within the source metal layer. The most significant compositional parameter, in addition to those of consequence from the standpoint of usual resist parameters, is the nature of the source metal layer with attention to its permitted diffusivity for the chosen metal.

Since the inventive advance depends upon lateral diffusion, a variety of parameters are controlled with a view to lateral diffusion. Interrelated parameters include (a) controlled amount of source metal to result in desired concentration gradient during photomigration; (b) exposure both as regards integrated exposure and time of exposure to result in desired photomigration; (c) thickness of the source metal layer with respect to the effect of this parameter on both types of metal movement; (d) nature and thickness of glassy layer largely with respect to matching other parameters to result in desired insolubilization or other required change in removability.

A significant aspect of the advance permits the use of unbiased masks in replication lithography. Removal of usual limitations on relative dimensions of features and gaps imposed by resists permits increased flexibility.

The resist

As in the past, the inorganic resist is dependent upon discrete region which generally take the form of successive layers on a supporting substrate. Usually, the layer in contact with the substrate surface is glassy. Preferred compositions are chalcogenides—e.g., of germanium/ selenium. Others include alternate chalcogenides—tellurium, sulphur, as well as selenium in admixture with germanium, arsenic, iodine, bismuth, etc. Glassy compositions may be binary, ternary, or more complex. Glass composition is not critical in most instances. Primary characteristics are those necessarily associated with usual lithographic resist functions. A compositional constraint does arise from the nature of the source metal layer, there being a general desire to have identity between an ingredient as contained in the glass and in the source metal regions.

The requirement of controlled—sometimes maximized—lateral diffusion directs attention to the source metal layer. It is generally desired that the diffusivity, $D_o$, for the metal be at least 0.01 times $10^{-6}$ cm$^2$/sec. (based on conductivity data). Many source metal compositions are available for use with silver. Suitable materials include those set forth in tabular form in a two or three digit absolute representation:

### TABLE

| Compound | $D_o \times 10^6$ (cm²/sec.) |
|---|---|
| α-AgI | 5.7 |
| α-Ag₂S | 5.3 |
| α-Ag₂Se | 4.8 |
| α-Ag₃SI | 2.8 |
| β-Ag₃SI | 0.027 or better |
| RbAg₄I₅ | 4.9 |
| α-Ag₂Te | 1.2 |
| Ag₂O | 3.7 |

Diffusivity data for other metal systems is available. See, for example, *Solid Electrolytes*, Edited by Paul Hagenmulle and W. Van Gool, Academic Press, New York, 1978, Chapters 14, 15, 17. The indicated diffusivity limit is generally preferred for usual lithographic processing in which throughput is a prominent consideration. Under other circumstances, desired tailoring may be attained by slower diffusivities.

It is expected that attention will continue to be directed to inorganic resist systems dependent upon photomigration of silver or copper. The inventive principles are equally applicable to other systems, such as those dependent upon thallium, mercury, lithium, and sodium. Specific examples are directed to the use of the source compound Ag₂Se with a glassy layer of Ge/Se. While by no means unique, the considerable investment due to extensive study results in specification of this system as preferred.

Other resist parameters

Other resist parameters are generally specified with a view to usual lithographic properties (although they may be optimized for specific results deriving from the inventive phenomena). Accordingly, thickness is desirably not substantially greater than the minimum feature size to be defined. Glassy materials contemplated may easily be deposited to produce continuous layers of controlled thickness of 300 nanometers (3,000 Angstrom units) and below as by evaporation or rf sputtering. Thicker layers may be produced by simple spray coating or dipping.

Processing

For ease of description, this section is in terms of the preferred embodiment which depends upon silver as the photomigrating species. In fact, nothing in the Processing section is specific to silver and suitable source metal layers, for example, containing copper, may be substituted with little or no change.

Much of the processing is similar or identical to that previously used with inorganic resist. Useful procedures are described, for example, in EP—

A—18 653. Briefly, a glass layer is applied by dipping, spray coating, sputtering, evaporation, etc. to a thickness dependent upon a number of considerations, such as feature size. It is known that a consideration involves glass composition and light source with a view to sufficient transparency to result in effective metal migration to the substrate-glass interface, and to desired absorption of most of the radiation to optimize sensitivity. These considerations concern sensitivity and light reflection from the substrate (known as the "standing wave" problem) and are generally unaffected by the inventive teaching.

Work to date has been rudimentary and little has been done to optimize rate of metal movement due to photomigration. Design parameters at a more sophisticated level may involve selection of conditions for glass application to control metal movement. It may, for example, be desirable to select deposition conditions for their effect on glass density.

Perhaps the most significant departure from usual practice concerns precise control of the amount of metal made available for photomigration in connection with suitable irradiation conditions. Reaction of the chalcogenide glass with an aqueous silver-containing solution is known to result in introduction of silver from solution to yield source silver which, in a preferred embodiment, may take the form of Ag₂Se. It is convenient to form source silver by interaction with solutions of compounds, such as KAg(CN)₂, AgCH₃COO, Ag(NH₃)₂NO₃, AgNO₃. In the preferred practice, silver is introduced in anionic form—e.g., (Ag(CN)₂)⁻. It has been found desirable, particularly for fine features, to avoid free elemental silver which, in the particular example, is accomplished by use of excess dissolved KCN. Contemplated silver compounds may also be produced by introduction of cationic silver.

The inventive requirement depends upon a significant lessening of silver concentration in the exposed region. It is implicit that a gradient sufficient to induce measurable lateral diffusion be present during some substantial fraction of exposure. It is convenient to specify this condition in terms of change in silver content in the source layer during exposure with final measurement made at a feature position removed from an edge. This requirement may be balanced with the conflicting demand for high sensitivity. For example, specification of essentially total removal of silver in the exposed region implies insufficient source material for increasing actinic induced insolubilization or other desired effect during the final stages of exposure and so reduces sensitivity. Under certain circumstances, such essentially complete removal may be desirable, although in general, some lesser change is desired. For these purposes, it is specified that there be at least a seventy five percent change in silver content in the source layer as measured at a center point in a large dimensioned irradiated region. From the standpoint of maximum edge acuity, silver as so measured is substantially completely removed. For most lithographic requirements to assure desired retained lithographic sensitivity, a silver change as so measured should result in residual silver of a maximum of 25%. The range may, therefore, be expressed as from 25% to 0%. The source metal layer has been chosen with attention to lateral diffusion. Limiting lateral diffusion is primarily in "dark" regions so that thinning of the source layer by exposure is not of primary concern.

Experimental work to date, as illustrated by the attached Examples, is based upon liquid development in which it is found that sufficient discrimination under usual processing conditions may result from introduction of up to about $10^{17}$ atoms of silver per square cm in the source silver layer. Examples yielded a measured value of $3 \times 10^{16}$ on the same basis. This is based on a silver source layer thickness of the order of 9 nm (90 Angstrom units). $10^{16}$ is considered a minimum under many conditions.

Irradiation conditions Irradiation conditions—e.g., wavelength, intensity, and time, are determined as before with two superimposed considerations. Exposure must be sufficient to result in depletion of silver as indicated (to a retained 25% or less as measured at a large illuminated region center point). The second consideration is due to relatively slow lateral diffusion. The requirement for measurable increase in edge acuity, in turn, gives rise to a requirement for a measurable increase in silver on the illuminated side of the light/dark interface relative to retained silver at the center of the illuminated region. This increase must be in evidence prior to termination of illumination so that lateral diffused silver may be made available for photomigration. Since edge acuity enhancement derives from depleted silver on the dark side of the interface, as well, the acuity enhancement is somewhat greater than indicated on the basis of such measurement. It has been found that an increase in source silver on the illuminated side of the light/dark interface of 20% at termination of exposure corresponds with a substantial increase in acuity. A preferred 50% on the same basis yields on acuity sufficient to result in constant line width for an exposure variation of ±10%. On the assumption that the illumination level is not deliberately perturbed, such a 20% increase as finally measured prior to stripping is specified as a minimum sufficient to meet the inventive requirements.

Source silver concentration either on initiation or termination of exposure is conveniently measured by X-ray fluorescence. The technique is described, for example, in *X-rays, Electrons, and Analytical Chemistry*, by H. A. Liebhafsky, H. G. Pfeiffer, E. H. Winslow, and P. D. Zemany, Wiley-Interscience (1972).

Radiation wavelength is as previously considered. See, for example EP—A—18653. Generally, chalcogenide glasses have sufficient absorption cross-section to be useful over the entire range of actinic radiation ordinarily used in lithographic processing—e.g., radiation up to about 430 nanometers (4300 Angstrom units). Very short wavelength, for example, X-ray may require deliberate inclusion of material having increased cross-section. Tellurium, bismuth, lead, as well as halide inclusion, are exemplary.

As shown by prior experience with inorganic resists, the nature of the duplex-layered structures does not lend itself naturally to electron beam lithography. For example, 10 kv electrons are absorbed only in a chalcogenide glass layer of a thickness of 500 nanometers (5,000 Angstrom units). Even increasing layer thickness to accommodate electron absorption does not assure expected sensitivity, since the photomigration mechanism requires substantial absorption in the outer region (within the source layer).

Nevertheless, other considerations may suggest use of the inventive approach in e-beam lithography. Virtual elimination of proximity effect may be of sufficient value in ensuring enhanced resolution to compensate for loss in lithographic sensitivity.

Development may take any of the forms described in EP—A—18653. Here the stripping of the metal source may involve single or mixed solvents—e.g., initial immersion in aqua regia, followed by immersion in aqueous KCN, followed by development in a basic solution containing an additive capable of dissolving elemental selenium. Alternatively, development may be based on a plasma-assisted procedure.

Examples

Example 1

This Example is concerned with an experimental procedure which establishes the fundamental phenomenon of lateral diffusion. While not actually directed to device fabrication, processing conditions are within the contemplated ranges, and the irradiation conditions have been chosen according to the considerations in the preceding chapter.

2.5 µm of a polymeric material based on a novolac—a substituted or unsubstituted thermoplastic (uncross-linked) copolymer of a phenolic monomer together with formaldehyde—is spun on a 7.6 centimeter (three-inch) Si wafer and the wafer is baked at 210 degrees C for two hours. 200 nanometers (2,000 Angstrom units) of $Ge_{.1}Se_{.9}$ are deposited on the baked polymer by electron beam evaporation. 9 nanometers (90 Angstrom units) of $Ag_2Se$ is then formed on the surface of the $Ge_{.1}Se_{.9}$ layer by dipping into a 0.25N $KAg(CN)_2$ solution at pH 11 for thirty seconds. After rinsing with DI water for one min. and drying in a stream of $N_2$ the wafer is exposed and then reexposed after the mask has been rotated by 90 degrees. The top $Ag_2Se$ layer is stripped by immersion in an aqueous 0.007M $KI_3$—2M KI bath for thirty seconds, rinsed and dried. The $Ge_{.1}Se_{.9}$ resist is then developed by immersion in a basic (AZ 351) developer to which 0.04 M $Na_2S$ is

added. The developer selectively etches the non-photodoped area. The first and second exposures should, in the absence of lateral silver transport, provide equally heavy patterns. This, however, is not the case. Silver migrates in the first exposure from the dark to the illuminated zones. Thus, there remains little silver on the surface, in the proximity of the exposed regions, for transport into the $Ge_{.1}Se_{.9}$ glass upon the second exposure. As a result, the pattern produced by the second exposure away from the first exposed area is thicker and more perfect than that produced near the first exposed areas.

Example 2

A multilayer resist structure is prepared exposed and processed as in Example 1. The pattern now consists of a 60 degree triangle. The concentration of silver is measured, point by point, by energy dispersive X-ray analysis. At the corner, itself, silver can diffuse laterally from 360 degrees–60 degrees=300 degrees. At other points along the side, this angle is reduced to 180 degrees. As expected for lateral diffusion from unexposed to exposed zones, the silver doping is heaviest at the sharp corner and declines as the distance from the corner increases.

Example 3

A multilayer resist structure is prepared, exposed and processed as in Example 1. The exposure dose is, however, below that required to produce a defect-free pattern. While the edges of the features form a perfect pattern of thin lines, their center is stripped, showing that there is less photodoping on the centers of illuminated zones than at their edges, to which silver can diffuse from nonilluminated or less illuminated regions.

Example 4

A multilayer resist structure is prepared, exposed and processed as in Example 1. The exposure tool used has an F/1.54 10× reduction lens, and the exposing light has a wavelength of 436 nm. Patterns of 0.5 μm lines and 0.5 μm spaces are printed. Printing of such a pattern shows that a modulation transfer function of 0.2 is adequate for the exposure of the $Ag_2Se/Ge_{.1}Se_{.9}$ resist. In the absence of lateral silver diffusion, for example, in polymer units, the smallest printable lines and spaces are of 0.75 μm.

Example 5

A multilayer resist structures is prepared, exposed, and processed as in Example 1. The pattern now consists of features with linear dimensions of 50 μm and 5 μm on the same mask. The 10:1 exposure tool and light source of Example 4 are used. Perfectly resolved features of precisely 5 μm and 0.5 μm linear dimensions are printed, showing that no mask bias is required for the simultaneous printing of large and small features. In the absence of lateral silver diffusion, for example, in polymeric resists, the smaller features require longer exposure times than the large ones and mask bias is required.

Example 6

A multilayer resist structure is prepared, exposed and processed as in Example 1. The exposure tool (10:1 reduction) and light source of Example 4 are used. 0.5 μm isolated lines and 0.5 m isolated gaps are simultaneously printed using a mask of 5 μm isolated lines and 5 μm isolated gaps. Assuming unit light intensity incident through a very large open area in the mask, it can be calculated that the light intensity in the center of an isolated line is of 0.3 and the light intensity at the center of the isolated gap is of 0.7. Thus, they should require different exposure times. Nevertheless, lateral silver diffusion makes the simultaneous printing of both isolated features possible.

Example 7

A multilayer resist structure is prepared, exposed and processed as in Example 1. The optimal exposure time is determined by measuring the correspondence between the dimensions of the printed features and those of the mask. Using the exposure tool and light source of Example 4, either an increase or a decrease of the exposure time by 7 percent produces a printed feature size variation of less than 20 nanometers (200 Angstrom units) for 0.75 μm lines and spaces. In a resist without lateral metal diffusion the dimensions of the printed features increase and decrease by 140 nanometers (1400 Angstrom units) under identical conditions and under identical variation in exposure.

Example 8

A resist structure similar to that of Example 1 is prepared, except that the $Ge_{.1}Se_{.9}$ glass is deposited directly onto a 7.6 centimeter (three-inch) silicon wafer. Exposure, processing, patterns and resolution and linewidth control are identical with those of Examples 1 through 7.

Example 9

A resist structure similar to that of Example 1 is produced, except that the $Ge_{.1}Se_{.9}$ film is replaced by a $GeS_2$ film, produced by thermal evaporation of the compound. An $Ag_2S$ layer, in which silver is laterally transported, is produced in a manner similar to that used for $Ge_{.1}Se_{.9}$. After exposure and stripping of the residual $Ag_2S$ from the surface by aqueous $KI_3$—KI, the pattern is developed by a dilute aqueous base, such as NaOH.

**Claims**

1. Process for fabrication of an article comprising at least one lithographic operation during which the article at least temporarily includes a glassy layer and a source metal material in contact with and overlaying said glassy layer, in which regions of the said source metal material are exposed to radiation from a radiation source which is modulated to produce regions demarcated by "light/dark" interfaces to cause migration of source metal into the said glassy layer primarily within irradiated regions thereby defining a pattern of glassy material of differing ease of removability, and effecting removal of the remaining source metal material and selective removal of glassy material by a developing agent, responsive to such differing ease of removability, characterized in that the source metal material comprises a metal in elemental and in ionic form, the amount of metal in the source metal material prior to the patterning exposure and the amount of radiation are chosen to result during a patterning exposure in a depletion of metal in the source metal material by a minimum of 75 percent within exposed regions, as measured by x-ray fluorescence, and, in consequence thereof, in a lateral diffusion of metal in an ionic form along the metal concentration gradient across the light/dark interfaces to increase the amount of metal effectively available for said radiation-assisted migration at the illuminated side of the interfaces prior to a termination of the patterning exposure, to produce enhanced edge acuity.

2. Process according to claim 1, characterized in that the amount of metal and the amount of radiation are chosen to result in a substantially complete metal removal from the source material as measured at a center point of a large exposed region.

3. Process according to claim 1, characterized in that the said metal is selected from silver, copper, thallium, and mercury.

4. Process according to claim 3, characterized in that the said metal is silver.

5. Process according to claim 4, characterized in that the said glassy material comprises a chalcogenide glass.

6. Process according to claim 4, characterized in that the said glassy material comprises Ge/Se.

7. Process according to claim 5 or 6, characterized in that the said chalcogenide glass consists of germanium and selenium.

8. Process according to any one of claims 5 or 6, characterized in that the said source metal material comprises $Ag_2Se$.

9. Process according to claim 4 or 5, characterized in that the said chalcogenide glass comprises Ge/S and the said source metal material comprises $Ag_2S$.

10. Process according to claim 1, characterized in that modulation to produce exposed regions is by means of a mask interposed between the article and the radiation source.

11. Process according to claim 10, characterized in that the said mask is "unbiased" with relative aperture/space dimension ratio that is desired on the said article.

**Patentansprüche**

1. Verfahren zum Herstellen eines Artikels, welches wenigstens eine lithographische Behandlung umfaßt, während der der Artikel wenigstens zeitweilig mit einer glasigen Schicht und einem auf der glasigen Schicht gelegenen und im Kontakt mit dieser befindlichen Quellenmetallmaterial versehen ist, wobei Zonen des Quellenmetallmaterials der Strahlung einer Strahlungsquelle exponiert werden, die zur Erzeugung von durch "Hell/Dunkel"-Grenzflächen markierten Zonen moduliert ist, um eine Wanderung von Quellenmetall in die glasige Schicht hauptsächlich innerhalb der bestrahlten Zonen zu verursachen und dadurch ein Glasmaterialmuster mit unterschiedlicher Leichtigkeit in der Entfernbarkeit zu definieren, und eine Entfernung das restlichen Quellenmetallmaterials sowie eine selektive Entfernung des glasigen Materials mit Hilfe eines Entwicklungsmittels in Abhängigkeit von der unterschiedlichen Entfernbarkeits-Leichtigkeit bewirkt wird, dadurch gekennzeichnet, daß das Quellenmetallmaterial ein Metall in elementarer und in ionischer Form umfaßt, die Metallmenge in dem Quellenmetallmaterial vor der mustermäßigen Bestrahlung und die Größe der Bestrahlung so gewählt werden, daß während einer mustermäßigen Bestrahlung eine Verarmung an Metall in dem Quellenmetallmaterial um wenigstens 75% innerhalb bestrahlter Bereiche, gemessen durch Röntgenstrahlungsfluoreszenz, resultiert und als Folge hiervon zu einer seitlichen Diffusion von Metall in ionischer Form längs des Metallkonzentrationsgradienten über die Hell/Dunkel-Grenzflächen hinweg führt, um die Metallmenge zu erhöhen, die für die strahlungsunterstützte Wanderung auf der bestrahlten Seite der Grenzflächen vor Beendigung der mustermäßigen Bestrahlung effektiv verfügbar ist, um so eine erhöhte Kantenschärfe zu erzeugen.

2. Verfahren nach Anspruch 1, dadurch gekennzeichnet daß, die Metallmenge und die Größe der Strahlung so gewählt werden, daß eine praktisch vollständige Metallentfernung aus dem Quellenmaterial, gemessen an einer zentralen Stelle einer großen bestrahlten Zone, resultiert.

3. Verfahren nach Anspruch 1, dadurch gekennzeichnet, daß das Metall aus Silber, Kupfer, Thallium und Quecksilber ausgewählt ist.

4. Verfahren nach Anspruch 3, dadurch gekennzeichnet, daß das Metall Silber ist.

5. Verfahren nach Anspruch 4, dadurch gekennzeichnet, daß das glasige Material ein Chalcogenid-Glas ist.

6. Verfahren nach Anspruch 4, dadurch gekennzeichnet, daß das glasige Material Ge/Se enthält.

7. Verfahren nach Anspruch 5 oder 6, dadurch gekennzeichnet, daß das Chalcogenid-Glas aus Germanium und Selen besteht.

8. Verfahren nach einem der Ansprüche 5 oder 6, dadurch gekennzeichnet, daß das Quellenmetallmaterial $Ag_2Se$ enthält.

9. Verfahren nach Anspruch 4 oder 5, dadurch gekennzeichnet, daß das Chalcogenid-Glas Ge/S und das Quellenmetallmaterial $Ag_2S$ enthalten.

10. Verfahren nach Anspruch 1, dadurch gekennzeichnet, daß die Modulation zur Erzeugung bestrahlter Zonen mit Hilfe einer Maske erfolgt, die zwischen dem Artikel und der Strahlungsquelle angeordnet ist.

11. Verfahren nach Anspruch 10, dadurch gekennzeichnet, daß die Maske mit relativem Öffnungs/Abstands-Dimensionsverhältnis, wie dieses auf dem Artikel gewünscht ist, "nicht vorgespannt" ist.

**Revendications**

1. Procédé de fabrication d'un produit comprenant au moins une opération lithographique pendant laquelle le produit comprend au moins temporairement une couche vitreuse et un matériau source de métal en contact et au-dessus de la couche vitreuse, dans lequel des régions du matériau source de métal sont exposées à un rayonnement à partir d'une source de rayonnement qui est modulée pour produire des régions séparées par des interfaces lumière/obscurité pour provoquer la migration du métal source dans la couche vitreuse essentiellement dans les régions irradiées, définissant ainsi des motifs de matériau vitreux à différentes facilités d'enlèvement, et dans lequel on enlève le matériau source de métal restant et on enlève sélectivement le matériau vitreux par un agent de développement, sensible à ces différences de facilité d'enlèvement, caractérisé en ce que: le matériau source de métal comprend un métal comprend un métal sous forme élémentaire et ionique, la quantité de métal dans le matériau source de métal avant l'exposition en forme de motif et la quantité de rayonnement sont choisies pour entraîner, pendant une exposition en forme de motifs, un appauvrissement en métal dans le matériau source de métal d'un minimum de 75% dans les régions exposées comme cela est mesuré par fluorescence aux rayons X et en conséquence une diffusion latérale du métal sous forme ionique selon un gradient de concentration de métal de part et d'autre de l'interface lumière/obscurité pour augmenter la quantité de métal effectivement disponible pour la migration assistée par rayonnement du côté éclairé de l'interface avant l'achèvement de l'exposition en forme de motifs pour produire une précision de définition de bords accrue.

2. Procédé selon la revendication 1, caractérisé en ce que la quantité de métal et la quantité de rayonnement sont choisies pour entraîner une suppression sensiblement complète du métal du matériau-source telle que mesurée au point central d'une région exposée de grandes dimensions.

3. Procédé selon la revendication 1, caractérisé en ce que le métal est choisi entre de l'argent, du cuivre, du thallium et du mercure.

4. Procédé selon la revendication 3, caractérisé en ce que le métal est de l'argent.

5. Procédé selon la revendication 4, caractérisé en ce que le matériau vitreux comprend un verre de chalcogénure.

6. Procédé selon la revendication 4, caractérisé en ce que le matériau vitreux comprend du Ge/Se.

7. Procédé selon l'une des revendications 5 ou 6, caractérisé en ce que le verre de chalcogénure comprend du germanium et du silicium.

8. Procédé selon l'une des revendications 5 ou 6, caractérisé en ce que le matériau source de métal comprend du $Ag_2Se$.

9. Procédé selon l'une des revendications 4 ou 5, caractérisé en ce que le verre au chalcogénure comprend Ge/S et le matériau source de métal $Ag_2S$.

10. Procédé selon la revendication 1, caractérisé en ce que la modulation pour produire des régions exposées se fait au moyen d'un masque interposé entre le produit et la source de rayonnement.

11. Procédé selon la revendication 10, caractérisé en ce que le masque n'est pas "distordu" en fonction du rapport des dimensions traits/intervalles que l'on désire obtenir sur le produit.